# EUROPÄISCHE PATENTSCHRIFT

(11) **EP 3 361 849 B1**
(45) Veröffentlichungstag und Bekanntmachung des Hinweises auf die Patenterteilung: **18.08.2021**
(21) Anmeldenummer: 18156489.9
(22) Anmeldetag: 13.02.2018
(51) Int. Cl.: H05K 7/20

(54) **ANORDNUNG FÜR EIN RECHENZENTRUM, RECHENZENTRUM MIT EINER DERARTIGEN ANORDNUNG, VERFAHREN ZUM BETRIEB EINER DERARTIGEN ANORDNUNG**
ARRANGEMENT FOR A COMPUTER CENTRE, COMPUTER CENTRE WITH SUCH AN ARRANGEMENT, METHOD FOR ITS USE
DISPOSITIF POUR UN CENTRE DE CALCUL, CENTRE DE CALCUL DOTÉ D'UN TEL DISPOSITIF, PROCÉDÉ DE FONCTIONNEMENT D'UN TEL DISPOSITIF

(30) Priorität: 14.02.2017 DE 102017102890; 19.12.2017 DE 102017130420
(43) Veröffentlichungstag der Anmeldung: 15.08.2018
(73) Patentinhaber: Zech Group SE, 28329 Bremen (DE)
(72) Erfinder: Lang, Stephan, 35394 Gießen (DE); Zultner, Holger, 72072 Tübingen (DE)
(74) Vertreter: Manasse, Uwe

(56) Entgegenhaltungen:
- EP-A1- 2 591 646
- US-A1- 2007 094 535
- US-A1- 2014 359 327

## Beschreibung

Die vorliegende Erfindung betrifft eine Anordnung für ein Rechenzentrum, ein Rechenzentrum mit einer derartigen Anordnung, ein Rechenzentrum mit mehreren derartigen Anordnungen und Verfahren zum Betrieb einer derartigen Anordnung oder zum Betrieb derartiger Rechenzentren. Die Anordnung ist vornehmlich für die Innenaufstellung, insbesondere in einem Gebäude, gedacht.

In Rechenzentren ist Computerhardware, wie z. B. Server, in größerer Stückzahl angeordnet, sodass für den Betrieb von Rechenzentren große Mengen an elektrischer Energie erforderlich sind. Neben der elektrischen Energie, die von dem IT-Komponenten benötigt wird, wird ein wesentlicher Teil dieser Energie von den Kühleinrichtungen, wie z. B. CRAC (Computer Room Air Conditioning) -Einheiten, verbraucht. Aus diversen Gründen ist dies häufig nicht ausreichend energieeffizient.

US 2007/094535 A1 offenbart eine Anordnung gemäß dem Oberbegriff von Anspruch 1.

EP 2 591 646 A1 offenbart Mittel zum Kühlen von IT-Komponenten.

Der vorliegenden Erfindung liegt somit die Aufgabe zugrunde, ein Rechenzentrum bereitzustellen, das noch leistungsfähiger ist.

Erfindungsgemäß wird diese Aufgabe durch ein Rechenzentrum mit einer Anordnung nach einem der Ansprüche 1-18 gelöst.

Gemäß einem Aspekt wird diese Aufgabe gelöst durch ein Rechenzentrum mit mehreren Anordnungen nach Anspruch 20, wobei die Anordnungen horizontal nebeneinander und/ oder horizontal hintereinander und/ oder vertikal übereinander angeordnet sind.

Gemäß einem Aspekt wird diese Aufgabe gelöst durch ein Verfahren nach Anspruch 21 zum Betrieb einer Anordnung nach einem der Ansprüche 1 bis 18 oder zum Betrieb eines Rechenzentrums nach Anspruch 19 oder 20, wobei eine IT-Komponente, insbesondere ein Server mittels eines Kommissionierungssystems vollautomatisch, in die Einhausung verbracht wird, Parameter einer Temperaturregelung an eine maximale Temperaturzulässigkeit der IT-Komponente(n) in der Anordnung angepasst werden, und die Temperaturregelung der Anordnung mit den angepassten Parametern betrieben wird.

Schließlich wird diese Aufgabe gemäß einem Aspekt gelöst durch ein Verfahren nach Anspruch 22 zum Betrieb einer Anordnung nach einem der Ansprüche 1 bis 18 oder zum Betrieb eines Rechenzentrums nach Anspruch 19 oder 20, wobei eine IT-Komponente, insbesondere ein Server, mittels eines Kommissionierungssystems vollautomatlisch aus der Einhausung entnommen wird, Parameter einer Temperaturregelung an eine maximale Temperaturzulässigkeit der verbleibenden IT-Komponenten in der Anordnung angepasst werden, und die Temperaturregelung der Anordnung mit den angepassten Parametern betrieben wird.

Bei der Anordnung kann die Einhausung als Warmgangeinhausung gestaltet sein. Es ist aber auch eine Kaltgangeinhausung möglich. Innen im eingehausten Gang ist dann die kalte Zuluft und außen im Raum/Umgebung ist die warme Abluft.

Gemäß einer besonderen Ausführungsform befindet sich gegenüber der ersten Rackreihe eine zweite Rackreihe für oder mit IT-Komponenten, insbesondere Server, zwischen denen der Gang verläuft. Der Gang wird dann links und rechts durch die Rackreihen, oben beispielsweise durch eine Klimatisierung, insbesondere Cooltop-Klimatisierung, unten vom Boden, vorne beispielsweise von einem Kommissionierungsterminal und hinten durch eine Wand eingehaust. So kann beispielsweise ein gehauster Warmgang entstehen.

Vorteilhafterweise umfasst das Mittel zum Kühlen der IT-Komponenten mindestens einen Ventilator, der oberhalb der Rackreihe, insbesondere über dem Gang, angeordnet ist, um erwärmte Luft aus der Einhausung abzuführen.

Zweckmäßigerweise umfasst das Mittel zum Kühlen mindestens ein Register, um die warme abzuführende Luft abzukühlen, insbesondere wobei es sich bei dem Register um ein Direktverdampferregister oder um ein wassergekühltes Register handelt.

Gemäß einer besonderen Ausführungsform der vorliegenden Erfindung befinden sich in der ersten Rackreihe und/oder zweite Rackreihe thermoelektrische Generatoren, die mittels des Temperaturunterschieds zwischen warmer IT-Komponente und Kühlmedium elektrischen Strom erzeugen können.

Vorteilhafterweise befinden sich die thermoelektrischen Generatoren auf wärmeabgebenden IT-Komponenten, insbesondere auf Prozessoren und/oder auf Netzteilen.

Vorteilhafterweise umfasst die Anordnung eine Batterie (Akku), die von den thermoelektrischen Generatoren gespeist werden kann.

Insbesondere kann dabei vorgesehen sein, dass die Anordnung eine unterbrechungsfreie Stromversorgung zur Versorgung der IT-Komponenten umfasst und die Batterie in die unterbrechungsfreie Stromversorgung eingebunden ist.

Zweckmäßigerweise wird/werden der mindestens eine Ventilator und/oder eine Beleuchtung der Anordnung und/oder eine Robotik in der Anordnung von der Batterie mit elektrischer Energie versorgt.

Erfindungsgemäß umfasst die Anordnung ein Terminal, mittels dessen die Übergabe von IT-Komponenten, wie z. B. Servern, an das Kommissionierungssystem erfolgen kann, wobei das Terminal an einer Stirnseite der Einhausung angeordnet ist, - vorzugsweise wobei das Terminal als IT-Komponenten-Eingabefach gestaltet ist - und als Klimaschleuse zwischen der Einhausung und deren Umgebung wirkt.

Vorteilhafterweise verfügt die Anordnung über ein IT-Komponenten-Verwaltungssystem und auch über Mittel, um IT-Komponenten, wie z. B. Server, die eingelagert oder ausgelagert werden, automatisch in das IT-Komponenten-Verwaltungssystem einzubuchen bzw. auszubuchen, wobei bevorzugt Betriebsdaten der IT-Komponenten im IT-Komponenten-Verwaltungssystem hinterlegt werden.

Insbesondere kann dabei vorgesehen sein, dass das Terminal über Mittel verfügt, um IT-Komponenten im Terminal zu identifizieren, damit sie im IT-Komponenten-Verwaltungssystem eingebucht oder ausgebucht werden können, insbesondere wobei die Identifizierung mittels eines Barcodescanners erfolgen kann.

Darüber hinaus kann vorgesehen sein, dass das IT-Komponenten-Verwaltungssystem so gestaltet ist, dass für jede IT-Komponente, die sich in der Anordnung befindet, eine maximale Temperaturzulässigkeit der IT-Komponente gespeichert ist, wobei es sich bevorzugt um eine maximale Zulufttemperatur oder eine maximale Rücklufttemperatur handelt, unter der die IT-Komponente in der Einhausung betreibbar ist.

Zweckmäßigerweise umfasst die Anordnung eine Temperaturregelung, die so ausgestaltet ist, dass eine Warmgangtemperatur so eingestellt wird, dass sie sich an der maximalen Temperaturzulässigkeit der IT-Komponente(n) orientiert.

Außerdem kann vorgesehen sein, dass die Anordnung so gestaltet ist, dass bei jeder Einlagerung oder Auslagerung einer IT-Komponente Parameter der Temperaturregelung angepasst werden, insbesondere unter Berücksichtigung der maximalen Temperaturzulässigkeit der sich in der Anordnung befindlichen IT-Komponenten, wie z. B. Server.

Insbesondere kann dabei vorgesehen sein, dass die Temperaturregelung so gestaltet ist, dass sich eine Rücklufttemperatur im Gang von mindestens 30°C, bevorzugt von mindestens 32°C, besonders bevorzugt von mindestens 35°C und ganz besonders bevorzugt von mindestens 39°C einstellt. In der Zukunft können die Temperaturen, die zu hoch wären, um für menschliche Mitarbeiter eine zulässige Umgebungstemperatur darzustellen, sogar noch höher sein.

Schließlich kann vorgesehen sein, dass die Anordnung eine biometrische Anwendererkennung beinhaltet, die bevorzugt als Handvenenscanner ausgeführt ist.

Der vorliegenden Erfindung liegt die überraschende Erkenntnis zugrunde, dass durch das Vorsehen einer Einhausung das IT-Equipment mit höheren Zuluft- und Ablufttemperaturen arbeiten kann, ohne dass Mitarbeiter den damit verbundenen höheren Temperaturen ausgesetzt werden müssen. Die "Thermal Guidelines for Data Processing Environments" von ASHRAE zeigen auf, dass IT-Equipments mit immer höheren Zuluft- und Abluft (Rückluft)-Temperaturen arbeiten können. Heutzutage zählen Zulufttemperaturen zu den IT-Komponenten von 25°C und AbluftTemperaturen von ca. 39°C als Standard-Temperaturen in einem Rechenzentrum. In "Thermal Guidelines for Data Processing Environments" Fourth Edition von ASHRAE (2015) geben die Komponentenhersteller für ihre neuen Produkte immer höhere mögliche Zuluft-Temperaturen an. Je höher die Zuluft-Temperatur ist, desto effizienter wird eine Klimatisierung eines Rechenzentrums. Ist eine Zuluft-Temperatur möglich, die jederzeit höher als die Außentemperatur (Umgebung) ist, kann auf eine mechanische Kälteerzeugung verzichtet werden. Die Wärmeabfuhr von den IT-Komponenten kann dann komplett über direkte oder indirekte freie Kühlung realisiert werden. Das führt zu einem immensen Einsparpotential im Bereich der Klimatisierung und somit werden Carpex- und Opex-Kosten deutlich gesenkt.

Höhere Temperaturen als 39°C im Warmbereich eines Rechenzentrums sind für Mitarbeiter sehr extreme Arbeitsbedingungen. Damit die Mitarbeiter nicht diesen Bedingungen (im Warmgang) ausgesetzt sind, kann gemäß einer besonderen Ausführungsform der vorliegenden Erfindung mindestens ein Roboter bzw. Robotersystem zur Automatisierung und Kommissionierung eingesetzt werden.

Zudem können die höheren Temperaturen gemäß einer besonderen Ausführungsform der vorliegenden Erfindung verwendet werden, um unter Verwendung von thermoelektrischen Generatoren aus der Abwärme elektrischen Strom zu erzeugen. Beispielsweise können die thermoelektrischen Generatoren genutzt werden, um kleine, dezentrale USV (Unterbrechungsfreie Stromversorgung)-Anlagen zu betreiben und so auf zentrale USV-Anlagen zu verzichten. Die thermoelektrischen Generatoren können auch ausreichend Strom erzeugen, um beispielsweise Ventilatoren der Klimatisierung zu betreiben.

Durch gemäß einer besonderen Ausführungsform der vorliegenden Erfindung Register, vorzugsweise Wärmeübertrager-Register, kann der effiziente Betrieb der Anordnung bzw. des Rechenzentrums -insbesondere bei zu erwartenden immer höher werdenden Temperaturen im Rechenzentrumsumfeld- noch verbessert werden.

Weitere Merkmale und Vorteile der Erfindung ergeben sich aus den beigefügten Ansprüchen und aus der nachfogenden Beschreibung von Ausführungsbeispielen anhand der schematischen Zeichnungen. Dabei zeigt:
- Figur 1: eine Draufsicht auf eine Anordnung gemäß einer besonderen Ausführungsform der vorliegenden Erfindung;
- Figur 2: eine perspektivische Ansicht der Anordnung von Figur 1;
- Figur 3: eine gegenüber der in der Figur 2 gezeigten Anordnung erweiterte Anordnung in perspektivischer Ansicht;
- Figur 4: eine Schnittansicht entlang der Linie IV-IV in Figur 1 nebst Luftströmung;
- Figur 5: eine Schnittansicht entlang der Linie V-V in Figur 1; und
- Figur 6: eine Schnittansicht ähnlich wie Figur 4, aber von einer Ausführungsfrom mit einer Kaltgangeinhausung.

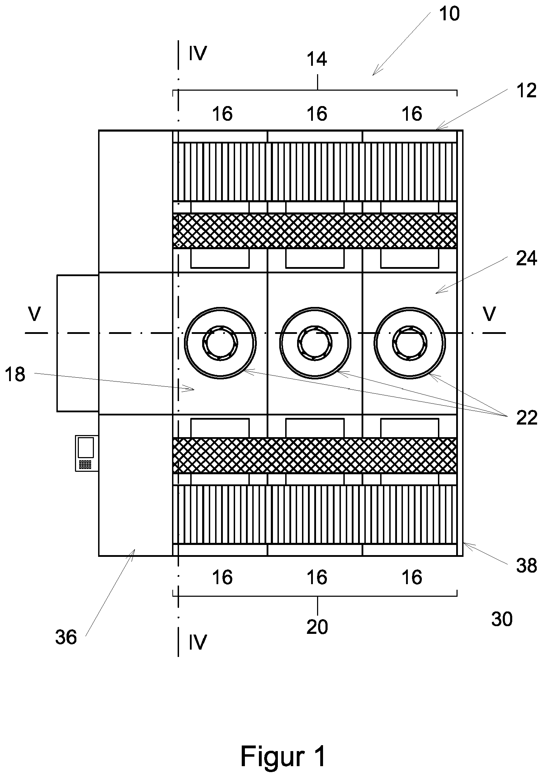

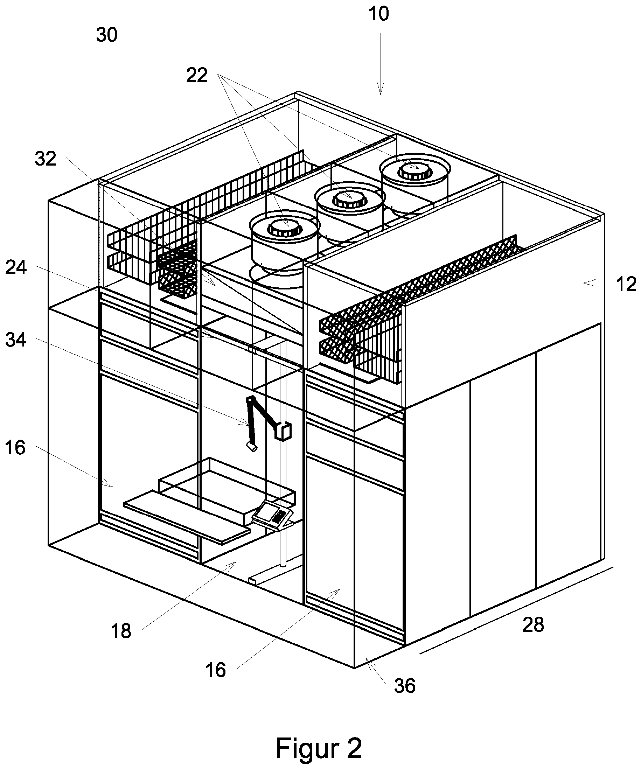

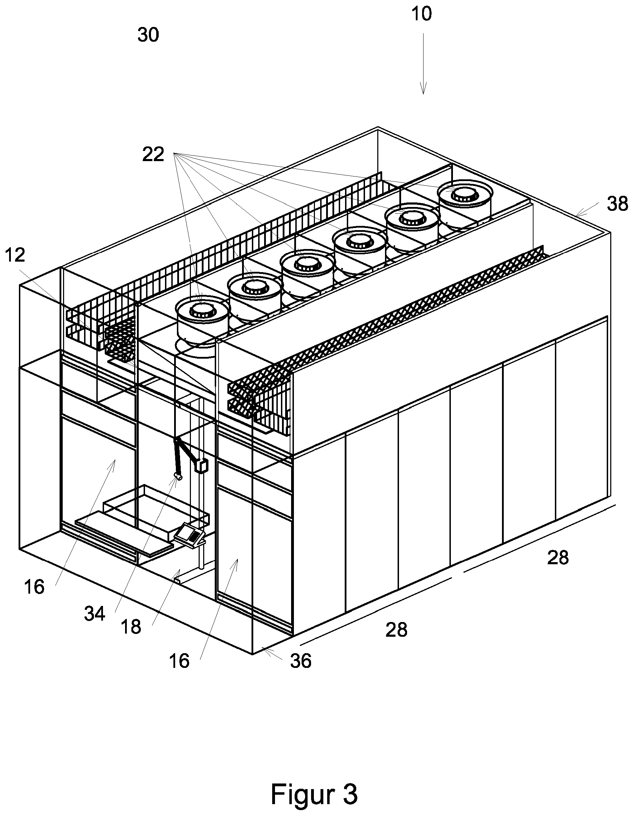

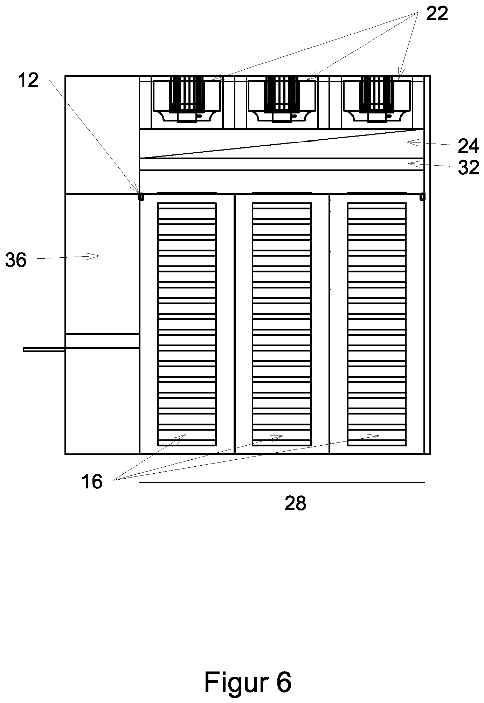

Die Figuren 1 und 2 zeigen eine Anordnung 10 für ein Rechenzentrum (nicht gezeigt) gemäß einer besonderen Ausführungsform der vorliegenden Erfindung, wobei die Anordnung in Modulbauweise (siehe Module 28 in den Figuren 1 bis 3) ausgeführt ist (s. a. Figur 3). Die Anordnung 10 umfasst eine Einhausung 12, eine darin angeordnete erste Rackreihe 14, die in diesem Beispiel drei nebeneinander angeordnete Racks 16 umfasst, aber in anderen Beispielen auch eine abweichende Anzahl und auch nur ein Rack umfassen kann, einen Gang 18 sowie eine zweite Rackreihe 20 gegenüber der ersten Rackreihe 14, zwischen denen der Gang 18 verläuft. Die Einhausung 12 ist als eine Warmgangeinhausung gestaltet. Mit anderen Worten ist der Gang 18 ein Warmgang, in den warme Luft strömt. Figur 6 zeigt eine Ausführungsform, bei der die Einhausung 12 als eine Kaltgangeinhasung gestaltet ist. Der Gang 18 ist dann ein Katlgang, in den kalte Luft strömt. Genauer gesagt ist dann innen im eingehausten Gang die kalte Zuluft und außen im Rauen / in der Umgebung die warem Abluft.

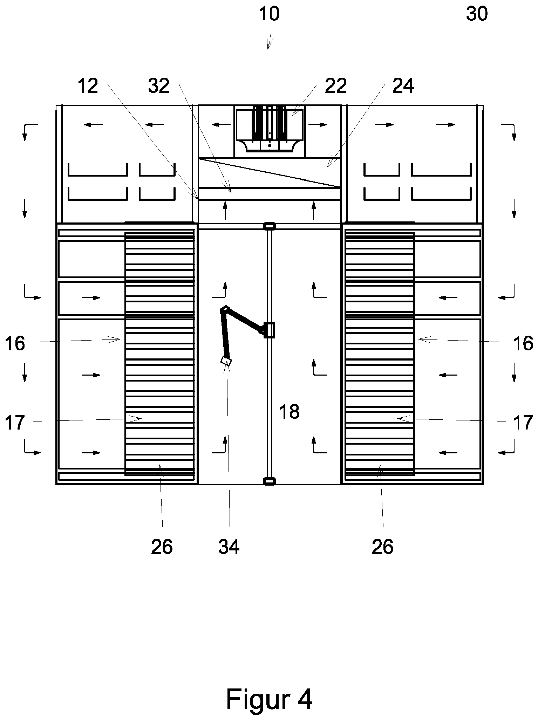

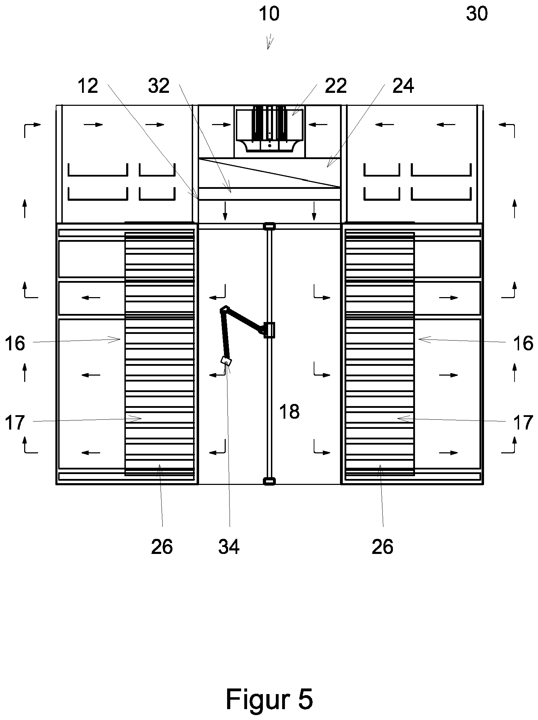

Wie sich aus den Figuren 1 bis 5 ergibt, sind oberhalb des Warmgangs 18 drei Ventilatoren 22, in diesem Beispiel zudem Radialventilatoren, in Längsrichtung des Gangs 18 hintereinander als Mittel zum Kühlen von Servern 17 (von denen nur wenige (s. Figur 4) gekennzeichnet sind) in den Racks 16 vorhanden. Genauer gesagt ist zwischen jedem Paar von gegenüberliegenden Racks 16 ein jeweiliger Ventilator 22 oberhalb der Racks angeordnet. Die Ventilatoren 22 sind in diesem Beispiel einzeln regelbar (je nach Wärmeabgabe im jeweiligen Segment). Sie saugen (warme) Luft aus dem Gang (Wärmegang) 18 nach oben ab. Um die warme abzuführende Luft abzukühlen, ist den Ventilatoren 22 ein Register 24 vorgeschaltet. Bei dem Register 24 kann es sich beispielsweise um ein Direktverdampferregister oder um ein wassergekühltes Register handeln.

Wie sich aus der Figur 4 (siehe insbesondere die Strömungspfeile dort) ergibt, strömt somit kühle Luft von außen in die Einhausung 12 über die Server 17 oder andere IT-Komponenten in den Racks 16 und nimmt die Wärme dieser Komponenten auf. Von den IT-Komponenten strömt die warme Luft in den innenliegenden Gang (Warmgang) 18. Die Ventilatoren 22 saugen die warme Luft aus dem Gang (Warmgang) 18 über das Register 24 an. In dem Register 24 wird die Wärme der Luft an ein Medium, das das Register 24 durchströmt, übertragen. Das Register kann beispielsweise klassisch mit Kaltwasser durchströmt werden. Jedoch sind auch beispielsweise Glykolgemische möglich, um das erwärmte Glykolwassergemisch direkt zu außenstehenden Rückkühlwerken (nicht gezeigt) zu leiten, oder aber kann das Register 24 mit Kältemittel durchströmt werden und so ein Kältemittelkreislauf installiert werden, bei dem das Register 24 als Verdampfer genutzt wird.

Auf beispielsweise der CPU der IT-Komponenten oder anderen sehr warmen Komponenten sind in diesem Ausführungsbeispiel (siehe Fig. 4) Thermoelemente 26 (von denen nur einige gekennzeichnet sind) installiert. Diese nutzen die hohe Temperaturdifferenz der IT-Komponenten etc. zur kühlen Luft, um einen Teil der Abwärme der Komponenten in elektrische Energie umzuwandeln. Mittels dieser erzeugten elektrischen Energie können beispielsweise dezentrale kleine USV-Anlagen (unterbrechungsfreie Stromversorgung, vereinfacht beispielsweise kleine Batterien)-Anlagen der einzelnen IT-Komponenten versorgt werden. Die USV-Anlagen sind beispielsweise einzeln jeder IT-Komponente zugeordnet und somit kann auf eine zentrale USV-Anlage verzichtet werden. Eine andere Möglichkeit wäre beispielsweise mittels der durch die Thermoelemente 26 erzeugten elektrischen Energie die Ventilatoren 22 zur Klimatisierung der Anordnung zu versorgen.

Wie sich ebenfalls aus der Figur 4 ergibt, sind die Ventilatoren 22 so gestaltet und angeordnet, dass die abgekühlte Luft seitlich in den Kaltraum 30 gestoßen bzw. geleitet wird. Dies hat den Vorteil, dass in dem gesamten Raum, in dem eine oder mehrere Anordnungen 10 stehen, die Temperatur der Zuluft eine gewünschte Temperatur (z.B. 25°C) aufweist und sich die Mitarbeiter nur in dem Raum mit der gemäßigten Lufttemperatur aufhalten.

Im Übrigen ist in diesem Beispiel dem Register 24 ein Luftfilter (Umluftfilter) 32 vorgeschaltet.

Je nach gewünschten Zu- und Rückluft (Abluft)temperaturen (Kaltraum- und Warmgangtemperatur) kann das Register 24 an ein Kaltwassernetz mit indirekter freier Kühlung und Kaltwassersatz angeschlossen werden. Alternativ kann das Register 24 gleich mit Kältemittel durchströmt werden und als Verdampfer dienen (hier wäre beispielsweise auch eine indirekte freie Kühlung oder DX-Betrieb möglich). Wenn es die Zulufttemperaturen zulassen, dann könnte hier auch komplett auf die mechanische Kälte verzichtet werden (kein Kaltwassersatz oder DX-System) und das Wasser könnte einfach über ein Rückkühlwerk die Wärme an die Umgebung abgeben.

Je nach gewählter Zu- und Rückluft (Abluft)temperatur und den Mediumtemperaturen im Register 24 können über die Anordnung unterschiedliche Leistungen abgefahren werden.

Zum Beispiel können bei einer Zulufttemperatur von 20°C, einer Rückluft (Abluft)temperatur von 35°C und bei einer Wassertemperatur von 15°C/21°C, das durch das Register 24 strömt, 15 kW pro Rack 16 abgefahren werden. Dies sind noch sehr zurückhaltende Werte. Bei höheren Zuluft- und Rückluft (Abluft)temperaturen kann auch mehr Leistung abgefahren werden.

Wie sich beispielsweise aus der Figur 3 ergibt, kann in einer besonderen Ausführungsform die bauliche Länge der Anordnung 10 frei und flexibel gewählt werden und nach der ersten Ausbaustufe weiter erweitert werden. Die in der Figur 3 gezeigte Aordnung 10 weist zwei in diesem Fall identische Module 28 auf.

Es hat sich gezeigt, dass eine sinnvolle Skalierungsgröße drei Racks 16 beispielsweise mit jeweils einer Breite von 800 mm auf jeder Seite des Gangs (Warmgangs) 18 ist. Bei einem Register 24 mit einer Länge von bspw. 2400 mm und einer Breite von bspw. 1200 mm ergeben sich die besten Skalierungsfaktoren mit jeweils drei Racks auf jeder Seite.

Da anstatt der Racks 16 auch beliebig vorgefertigte Regale, wie z.B. Stahlgerüstregale, für die Aufnahme gut geeignet sind und die Register auch genau auf die jeweiligen Längen angepasst werden können, kann die Skalierung auch komplett frei gewählt werden.

So entsteht ein intelligentes, flexibles und nachhaltiges High-Tech-Rechenzentrums-Komplettsystem, das nahezu in allen Räumlichkeiten eingesetzt werden kann und auf effektive Weise die immer höher erlaubten Zulufttemperaturen für die IT-Komponenten ausnutzt und so die energetische Effizienz deutlich steigert.

Die Anordnung kann auch zusätzlich mit folgenden Standardausrüstungen bestückt sein:
- Brandmelder,
- Gaslöschung,
- Energiemanagement.

Höhere Temperaturen als 39°C im warmen Bereich eines Rechenzentrums sind für Mitarbeiter sehr extreme Arbeitsbedingungen. Bei der Anordnung gemäß einer besonderen Ausführungsform der vorliegenden Erfindung ist der Warmbereich als Gang (Warmgang) 18 komplett eingehaust. Die Bestückung der Racks 16 (Regale bzw. (Stahl-)Konstruktionen zur Aufnahme von IT-Komponenten, insbesondere Servern) erfolgt gemäß einer besonderen Ausführungsform im Gang (Warmgang) 18 durch ein Robotersystem.

Ein Robotersystem dient als ein Kommissionierungssystem und weist einen Greifroboter 34 (siehe Figuren 2-4) auf, der sich auf Laufschienen (nicht gezeigt) mit einem Schrittmotor (nicht gezeigt) über die gesamte Länge einer oder mehrerer Rackreihen bewegen kann. Durch den Schrittmotor erfolgt eine exakte Positionierung. Zwischen den oberen und unteren Längsschienen ist eine vertikale Querschiene (nicht gezeigt) geführt, über die der Greifroboter 34 die Position jeder IT-Komponente, egal auf welcher Seite und in welcher Höhenposition, in einem jeweiligen Rack erreichen kann.

Gemäß einer besonderen Ausführungsform werden die IT-Komponenten über ein Plug & Play-System mit Strom und Daten versorgt. Dieses Plug & Play-System ermöglicht es, dass der Greifroboter 34 die IT-Komponenten problemlos herausziehen und wechseln kann. Diese Aktivitäten kann der Greifroboter vollkommen autonom durchführen. Zur Kommissionierung gibt es an der Frontseite ein Kommissionierungs-Terminal 36, bei dem Mitarbeiter neue IT-Komponenten (Hardware) aufgeben können oder die genutzten IT-Komponenten entnehmen können. Dabei steht der Mitarbeiter immer im Bereich des Kaltraumes 30. Der Greifroboter 34 ist für die hohen Temperaturen im Gang (Warmgang) 18 ausgelegt und kann einwandfrei in dieser warmen Umgebung (bis über ca. 60°C) arbeiten.

Ein Verfahren zum Betrieb einer Anordnung, beispielsweise einer Anordnung 10 gemäß den Figuren 1, 2, 4 und 5 beziehungsweise einer Anordnung 10 gemäß den Figuren 1, 3, 4 und 5 beziehungsweise eines Rechenzentrums mit einer entsprechenden Anordnung, kann gemäß einer besonderen Ausführungsform der vorliegenden Erfindung wie folgt aussehen:
Eine IT-Komponente, wie beispielsweise ein Server (beispielsweise Server 17), wird in die Einhausung (wie beispielsweise Einhausung 12) verbracht, Parameter einer Temperaturregelung werden an eine maximale Temperaturzulässigkeit (zulässige Temperatur) der IT-Komponente(n) in der Anordnung angepasst und eine Temperaturregelung (nicht gezeigt) der Anordnung wird mit den angepassten Parametern betrieben.

Ein Verfahren zum Betrieb einer Anordnung, wie z. B. einer in den Figuren 1 bis 5 gezeigten Anordnung, oder eines Rechenzentrums, beispielsweise mit einer derartigen Anordnung, gemäß einer besonderen Ausführungsform der vorliegenden Erfindung umfasst:
Eine IT-Komponente, insbesondere ein Server, wie z. B. ein Server 17, wird aus der Einhausung, wie z. B. der Einhausung 12, entnommen, Parameter einer Temperaturregelung (nicht gezeigt) werden an eine maximale Temperaturzulässigkeit (zulässige Temperatur) der verbleibenden IT-Komponenten in der Anordnung angepasst, und die Temperaturregelung der Anordnung wird mit den angepassten Parametern betrieben.
Eine Anordnung kann angeforderte oder eingegebene IT-Komponente, wie z. B. Server, innerhalb weniger Sekunden in den Entnahmebereich bringen und diese können dann dort in ergonomischer Höhe ausgelagert werden. Nicht der Mensch geht zur Ware, sondern die Ware kommt zum Menschen. Die Zugriffszeiten werden entscheidend verkürzt und die Kommissionierungsleistung erheblich gesteigert. Durch beispielsweise ein Barcodescanning im IT-Komponenten-Eingabefach kann ein optimales Data Center Infrastructure Management realisiert werden.

Das ergonomische Einladen beispielsweise der Serversysteme in eine Server-Handling-Unit (SHU) zur Rechenzentrum-Automaisierung minimiert die körperliche Belastung der Mitarbeiter.

Die Anordnung ist aufgrund einer möglichen Standardisierung eine schnell integrierbare, überall einsetzbare Lösung. Ob in Bestandsimmobilien mit einem Kernnutzungskonzept für Rechenzentren wie Cloud Data Center, Colocation oder Housing, zweckentfremdete Immobilien aus der Industrieproduktion oder Edge Data Center- Konzepte.

Zumindestens in einer besonderen Ausführungsform spart eine derartige Anordnung auf einer Fläche von ca. 1000 qm IT-Whitespace ca. 30 % an Fläche gegenüber herkömmlichen Rechenzentren mit klassischem Warmgang/Kaltgang-Prinzip und nutzt die vorhandenen Flächen optimal aus. Entsprechend der Raumhöhe ist das System der Anordnung nicht nur in der Horizontalen sondern auch in der Vertikalen skalierbar.

Mittels der Anordnung werden IT-Komponenten, insbesondere Server- Komponenten ohne Raumverlust höhenoptimiert eingelagert. Somit entsteht auf kleinster Grundfläche ein Maximum an Lagerkapazität. Das spart Kosten und hilft, die Fläche bebauten Raumes ökonomischer zu benutzen.

Die in der vorstehenden Beschreibung, in den Zeichnungen sowie in den Ansprüchen offenbarten Merkmale der Erfindung können sowohl einzeln als auch in den beliebigen Kombinationen für die Verwirklichung der Erfindung in ihren verschiedenen Ausführungsformen wesentlich sein.

## Patentansprüche

1. Anordnung (10) für ein Rechenzentrum, umfassend eine Einhausung (12) und eine darin angeordnete erste Rackreihe (14), für oder mit IT-Komponenten, insbesondere Server (17), wobei sich in der Einhausung (12) vor der ersten Rackreihe (14) ein Gang (18) befindet,
und die Einlagerung von IT-Komponenten in die Rackreihe oder die Auslagerung von IT-Komponenten aus der Rackreihe vom Gang (18) her erfolgen kann,
wobei die Anordnung über ein Mittel zum Kühlen der IT-Komponenten verfügt und ein Terminal umfasst, das an einer Stirnseite der Einhausung angeordnet ist, **dadurch gekennzeichnet,**
**dass** das Terminal als Klimaschleuse zur Übergabe von IT-Komponenten zwischen der Einhausung und deren Umgebung wirkt und dass die Anordnung ein Kommissionierungssystem zum vollautomatischen Einlagern und Auslagern von IT-Komponenten, insbesondere Servern, in die Rackreihe(n) umfasst, insbesondere wobei das Kommissionierungssystem einen über vorzugsweise die gesamte Rackreihenlänge bewegbaren Roboter beinhaltet.

2. Anordnung (10) nach Anspruch 1, wobei die Einhausung (12) als Warmgangeinhausung gestaltet ist.

3. Anordnung (10) nach einem der vorhergehenden Ansprüche, wobei sich gegenüber der ersten Rackreihe (14) eine zweite Rackreihe (20) für oder mit IT-Komponenten, insbesondere Server (17), befindet, zwischen denen der Gang (18) verläuft.

4. Anordnung (10) nach einem der vorhergehenden Ansprüche, wobei das Mittel zum Kühlen der IT-Komponenten mindestens einen Ventilator (22) umfasst, der oberhalb der Rackreihe (n), insbesondere über dem Gang (18), angeordnet ist, um erwärmte Luft aus der Einhausung (12) abzuführen.

5. Anordnung (10) nach einem der vorhergehenden Ansprüche, wobei das Mittel zum Kühlen mindestens ein Register (24) umfasst, um die warme abzuführende Luft abzukühlen, insbesondere wobei es sich bei dem Register um ein Direktverdampferregister oder um ein wassergekühltes Register handelt.

6. Anordnung (10) nach einem der vorhergehenden Ansprüche, wobei sich in der ersten Rackreihe (14) und/oder der zweiten Rackreihe (20) thermoelektrische Generatoren befinden, die mittels eines Temperaturunterschieds elektrischen Strom erzeugen können.

7. Anordnung (10) nach Anspruch 6, wobei sich die thermoelektrischen Generatoren auf wärmeabgebenden IT-Komponenten, insbesondere auf Prozessoren und/oder auf Netzteilen, befinden.

8. Anordnung (10) nach Anspruch 6 oder 7, wobei die Anordnung eine Batterie umfasst, die von den thermoelektrischen Generatoren gespeist werden kann.

9. Anordnung (10) nach Anspruch 8, wobei die Anordnung eine unterbrechungsfreie Stromversorgung zur Versorgung der IT-Komponenten umfasst und die Batterie in die unterbrechungsfreie Stromversorgung eingebunden ist.

10. Anordnung (10) nach Anspruch 8 oder 9, wobei der mindestens eine Ventilator (22) und/oder eine Beleuchtung der Anordnung und/oder eine Robotik in der Anordnung von der Batterie mit elektrischer Energie versorgt wird.

11. Anordnung (10) nach einem der vorangehenden Ansprüche, wobei die Anordnung (10) ein Terminal umfasst, mittels dessen die Übergabe von IT-Komponenten, wie z. B. Servern, an das Kommissionierungssystem erfolgen kann, vorzugsweise wobei das Terminal als IT-Komponenten-Eingabefach gestaltet ist.

12. Anordnung (10) nach einem der vorhergehenden Ansprüche, wobei die Anordnung über ein IT-Komponenten-Verwaltungssystem und auch über Mittel verfügt, um IT-Komponenten, die eingelagert oder ausgelagert werden, automatisch in das IT-Komponenten-Verwaltungssystem einzubuchen bzw. auszubuchen, wobei bevorzugt Betriebsdaten der IT-Komponenten im IT-Komponenten-Verwaltungssystem hinterlegt werden.

13. Anordnung (10) nach Anspruch 12 mit Anspruch 11, wobei das Terminal über Mittel verfügt, um IT-Komponenten im Terminal zu identifizieren, damit sie im IT-Komponenten-Verwaltungssystem eingebucht oder ausgebucht werden können, insbesondere wobei die Identifizierung mittels eines Barcodescanners erfolgen kann.

14. Anordnung (10) nach Anspruch 12 oder Anspruch 13, wobei das IT-Komponenten-Verwaltungssystem so gestaltet ist, dass für jede IT-Komponente, die sich in der Anordnung befindet, eine maximale Temperaturzulässigkeit der IT-Komponente gespeichert ist, wobei es sich bevorzugt um eine maximale Zulufttemperatur oder eine maximale Rücklufttemperatur handelt, unter der die IT-Komponente in der Einhausung betreibbar ist.

15. Anordnung (10) nach einem der Ansprüche 2 bis 14, wobei die Anordnung eine Temperaturregelung umfasst, die so ausgestaltet ist, dass eine Warmgangtemperatur so eingestellt wird, dass sie sich an der maximalen Temperaturzulässigkeit der IT-Komponente(n) orientiert.

16. Anordnung (10) nach Anspruch 15 mit Anspruch 14, wobei die Anordnung so gestaltet ist, dass bei jeder Einlagerung oder Auslagerung einer IT-Komponente Parameter der Temperaturregelung angepasst werden, insbesondere unter Berücksichtigung der maximalen Temperaturzulässigkeit der sich in der Anordnung befindlichen IT-Komponenten, wie z. B. Server (17).

17. Anordnung (10) nach einem der Ansprüche 15 oder 16, wobei die Temperaturreglung so gestaltet ist, dass sich eine Rücklufttemperatur im Gang von mindestens 30°C, bevorzugt von mindestens 32°C, besonders bevorzugt von mindestens 35°C und ganz besonders bevorzugt von mindestens 39°C einstellt.

18. Anordnung (10) nach einem der vorhergehenden Ansprüche, wobei die Anordnung eine biometrische Anwendererkennung beinhaltet, die bevorzugt als Handvenenscanner ausgeführt ist.

19. Rechenzentrum mit einer Anordnung (10) nach einem der vorangehenden Ansprüche.

20. Rechenzentrum mit mehreren Anordnungen (10) nach einem der Ansprüche 1 bis 18, wobei die Anordnungen horizontal nebeneinander und/oder horizontal hintereinander und/oder vertikal übereinander angeordnet sind.

21. Verfahren zum Betrieb einer Anordnung (10) nach einem der Ansprüche 1 bis 18 oder zum Betrieb eines Rechenzentrums nach Anspruch 19 oder 20, wobei
- eine IT-Komponente, insbesondere ein Server (17), mittels eines Kommissionierungssystems vollautomatisch in die Einhausung (12) verbracht wird,
- Parameter einer Temperaturregelung an eine maximale Temperaturzulässigkeit der IT-Komponente(n) in der Anordnung angepasst werden, und
- die Temperaturregelung der Anordnung mit den angepassten Parametern betrieben wird.

22. Verfahren zum Betrieb einer Anordnung (10) nach einem der Ansprüche 1 bis 18 oder zum Betrieb eines Rechenzentrums nach Anspruch 19 oder 20, wobei
- eine IT-Komponente, insbesondere ein Server (17), mittels eines Kommissionierungssystems vollautomatlisch aus der Einhausung (12) entnommen wird,
- Parameter einer Temperaturregelung an eine maximale Temperaturzulässigkeit der verbleibenden IT-Komponenten in der Anordnung angepasst werden, und
- die Temperaturregelung der Anordnung mit den angepassten Parametern betrieben wird.

## Claims

1. Arrangement (10) for a data centre, comprising an enclosure (12) and a first series of racks (14) arranged therein, for or containing IT components, in particular servers (17), an aisle (18) being located in the enclosure (12) in front of the first series of racks (14),
and IT components are able to be inserted into the series of racks or IT components are able to be removed from the series of racks from the aisle (18),
wherein the arrangement has a means for cooling the IT components and comprises a terminal that is arranged on an end face of the enclosure, **characterized in that** the terminal acts as a temperature control airlock for the transfer of IT components between the enclosure and their environment and **in that** the arrangement comprises a picking system for the fully automatic insertion and removal of IT components, in particular servers, into and from the one or more series of racks, in particular wherein the picking system contains a robot able to be moved over preferably the entire length of the series of racks.

2. Arrangement (10) according to Claim 1, wherein the enclosure (12) is designed as a hot-aisle enclosure.

3. Arrangement (10) according to either of the preceding claims, wherein a second series of racks (20) for or containing IT components, in particular servers (17), is located opposite the first series of racks (14), the aisle (18) running between them.

4. Arrangement (10) according to one of the preceding claims, wherein the means for cooling the IT components comprises at least one fan (22) that is arranged above the one or more series of racks, in particular above the aisle (18), in order to channel heated air out of the enclosure (12).

5. Arrangement (10) according to one of the preceding claims, wherein the cooling means comprises at least one register (24) in order to cool the hot air to be channelled away, in particular wherein the register is a direct evaporation register or a water-cooled register.

6. Arrangement (10) according to one of the preceding claims, wherein the first series of racks (14) and/or the second series of racks (20) contain thermoelectric generators that are able to generate electric current by way of a temperature difference.

7. Arrangement (10) according to Claim 6, wherein the thermoelectric generators are located on heat-emitting IT components, in particular on processors and/or on power supplies.

8. Arrangement (10) according to Claim 6 or 7, wherein the arrangement comprises a battery that is able to be supplied by the thermoelectric generators.

9. Arrangement (10) according to Claim 8, wherein the arrangement comprises an uninterruptible power supply for supplying power to the IT components and the battery is incorporated into the uninterruptible power supply.

10. Arrangement (10) according to Claim 8 or 9, wherein the at least one fan (22) and/or an illumination system of the arrangement and/or a robotics system in the arrangement is supplied with electrical energy by the battery.

11. Arrangement (10) according to one of the preceding claims, wherein the arrangement (10) comprises a terminal by way of which it is possible to transfer IT components, such as for example servers, to the picking system, preferably wherein the terminal is designed as an IT component feeder.

12. Arrangement (10) according to one of the preceding claims, wherein the arrangement has an IT component management system and also means for automatically booking in or booking out IT components that are inserted or removed into the IT component management system, wherein operating data of the IT components are preferably stored in the IT component management system.

13. Arrangement (10) according to Claim 12 with Claim 11, wherein the terminal has means for identifying IT components in the terminal, so that they are able to be booked into or booked out of the IT component management system, in particular wherein the identification is able to be performed by way of a barcode scanner.

14. Arrangement (10) according to Claim 12 or Claim 13, wherein the IT component management system is designed such that a maximum permissible temperature of an IT component is stored for each IT component that is contained in the arrangement, this preferably being a maximum feed air temperature or a maximum return air temperature at which the IT component in the enclosure is able to be operated.

15. Arrangement (10) according to one of Claims 2 to 14, wherein the arrangement comprises a temperature control system that is designed such that a hot aisle temperature is set such that it is aligned with the maximum permissible temperature of the one or more IT components.

16. Arrangement (10) according to Claim 15 with Claim 14, wherein the arrangement is designed such that, upon each insertion or removal of an IT component, parameters of the temperature control system are adjusted, in particular taking into consideration the maximum permissible temperature of the IT components, such as for example servers (17), contained in the arrangement.

17. Arrangement (10) according to either of Claims 15 and 16, wherein the temperature control system is designed such that it sets a return air temperature in the aisle of at least 30°C, preferably of at least 32°C, particularly preferably of at least 35°C and very particularly preferably of at least 39°C.

18. Arrangement (10) according to one of the preceding claims, wherein the arrangement contains a biometric user identification system that is preferably in the form of a hand vein scanner.

19. Data centre containing an arrangement (10) according to one of the preceding claims.

20. Data centre containing a plurality of arrangements (10) according to one of Claims 1 to 18, wherein the arrangements are arranged horizontally next to one another and/or horizontally behind one another and/or vertically above one another.

21. Method for operating an arrangement (10) according to one of Claims 1 to 18 or for operating a data centre according to Claim 19 or 20, wherein
- an IT component, in particular a server (17), is brought fully automatically into the enclosure (12) by way of a picking system,
- parameters of a temperature control system are adjusted to a maximum permissible temperature of the one or more IT components in the arrangement, and
- the temperature control system of the arrangement is operated with the adjusted parameters.

22. Method for operating an arrangement (10) according to one of Claims 1 to 18 or for operating a data centre according to Claim 19 or 20, wherein
- an IT component, in particular a server (17), is removed fully automatically from the enclosure (12) by way of a picking system,
- parameters of a temperature control system are adjusted to a maximum permissible temperature of the remaining IT components in the arrangement, and
- the temperature control system of the arrangement is operated with the adjusted parameters.

## Revendications

1. Arrangement (10) pour un centre de calcul, comprenant une enveloppe (12) et une première rangée de baies (14) disposée dans celle-ci, pour ou comprenant des composants informatiques, notamment des serveurs (17), une allée (18) se trouvant dans l'enveloppe (12) devant la première rangée de baies (14),
et l'incorporation de composants informatiques dans la rangée de baies ou l'extraction de composants informatiques hors de la rangée de baies peut être effectuée depuis l'allée (18),
l'arrangement disposant de moyens servant au refroidissement des composants informatiques et comportant un terminal qui est disposé au niveau d'un côté frontal de l'enveloppe, **caractérisé en ce que** le terminal agit en tant que sas climatique pour le transfert des composants informatiques entre l'enveloppe et leur environnement et
**en ce que** l'arrangement comporte un système de préparation de commandes pour l'incorporation et l'extraction entièrement automatiques de composants informatiques, notamment de serveurs, dans la ou les rangées de baies, le système de préparation de commandes incluant notamment un robot qui peut se déplacer de préférence sur toute la longueur de la rangée de baies.

2. Arrangement (10) selon la revendication 1, l'enveloppe (12) étant configurée en tant qu'enveloppe à allée chaude.

3. Arrangement (10) selon l'une des revendications précédentes, une deuxième rangée de baies (20) se trouvant en vis-à-vis de la première rangée de baies (14), pour ou comprenant des composants informatiques, notamment des serveurs (17), entre lesquelles s'étend une allée (18).

4. Arrangement (10) selon l'une des revendications précédentes, les moyens servant au refroidissement des composants informatiques comprenant au moins un ventilateur (22), lequel est disposé au-dessus de la rangée de baies (n), notamment au-dessus de l'allée (18), afin d'évacuer l'air chauffé hors de l'enveloppe (12).

5. Arrangement (10) selon l'une des revendications précédentes, les moyens servant au refroidissement des composants informatiques comprenant au moins un registre (24), afin de refroidir l'air chaud à évacuer, le registre étant notamment un registre à évaporateur direct ou un registre à refroidissement par eau.

6. Arrangement (10) selon l'une des revendications précédentes, des générateurs thermoélectriques se trouvant dans la première rangée de baies (14) et/ou la deuxième rangée de baies (20), lesquels peuvent générer du courant électrique au moyen d'une différence de température.

7. Arrangement (10) selon la revendication 6, les générateurs thermoélectriques se trouvant sur des composants informatiques dissipant de la chaleur, notamment sur des processeurs et/ou sur des parties de réseau.

8. Arrangement (10) selon la revendication 6 ou 7, l'arrangement comprenant une batterie qui peut être alimentée par les générateurs thermoélectriques.

9. Arrangement (10) selon la revendication 8, l'arrangement comprenant une alimentation électrique ininterruptible destinée à alimenter les composants informatiques et la batterie étant intégrée dans l'alimentation électrique ininterruptible.

10. Arrangement (10) selon la revendication 8 ou 9, l'au moins un ventilateur (22) et/ou un éclairage de l'arrangement et/ou un système robotique dans l'arrangement étant alimenté par la batterie avec de l'énergie électrique.

11. Arrangement (10) selon l'une des revendications précédentes, l'arrangement (10) comprenant un terminal au moyen duquel peut être effectué le transfert des composants informatiques, par exemple des serveurs, au système de préparation de commandes, le terminal étant de préférence configuré en tant que compartiment d'incorporation de composants informatiques.

12. Arrangement (10) selon l'une des revendications précédentes, l'arrangement disposant d'un système de gestion des composants informatiques ainsi que de moyens destinés à enregistrer automatiquement dans le système de gestion des composants informatiques, ou à l'en retirer, les composants informatiques qui doivent être incorporés ou extraits, des données opérationnelles des composants informatiques étant de préférence stockées dans le système de gestion des composants informatiques.

13. Arrangement (10) selon la revendication 12 avec la revendication 11, le terminal disposant de moyens destinés à identifier les composants informatiques dans le terminal, afin qu'ils puissent être enregistrés dans le système de gestion des composants informatiques ou en être retirés, l'identification pouvant notamment être effectuée au moyen d'un lecteur de code à barres.

14. Arrangement (10) selon la revendication 12 ou la revendication 13, le système de gestion des composants informatiques étant configuré de telle sorte qu'une température admissible maximale des composants informatiques est mémorisée pour chaque composant informatique qui se trouve dans l'arrangement, celle-ci étant de préférence une température maximale d'air arrivant ou une température maximale d'air de retour sous laquelle peuvent fonctionner les composants informatiques dans l'enveloppe.

15. Arrangement (10) selon l'une des revendications 2 à 14, l'arrangement comprenant une régulation de température qui est configurée de telle sorte qu'une température d'allée chaude est réglée de manière à ce qu'elle s'oriente sur la température admissible maximale du ou des composants informatiques.

16. Arrangement (10) selon la revendication 15 avec la revendication 14, l'arrangement étant configuré de telle sorte que lors de chaque incorporation ou retrait d'un composant informatique, les paramètres de la régulation de température sont adaptés, notamment en tenant compte de la température admissible maximale des composants informatiques, par exemple des serveurs (17), qui se trouvent dans l'arrangement.

17. Arrangement (10) selon l'une des revendications 15 ou 16, la régulation de température étant configurée de telle sorte qu'une température d'air de retour minimale de 30 °C, de préférence d'au moins 32 °C, notamment de préférence d'au moins 35 °C et tout particulièrement de préférence d'au moins 39 °C s'établit dans l'allée.

18. Arrangement (10) selon l'une des revendications précédentes, l'arrangement comportant une reconnaissance biométrique d'utilisateur, laquelle est de préférence réalisée sous la forme d'un dispositif de lecture des veines de la main.

19. Centre de calcul comprenant un arrangement (10) selon l'une des revendications précédentes.

20. Centre de calcul comprenant plusieurs arrangements (10) selon l'une des revendications 1 à 18, les arrangements étant disposés horizontalement les uns à côté des autres et/ou horizontalement les uns au-dessus des autres et/ou verticalement les uns au-dessus des autres.

21. Procédé pour faire fonctionner un arrangement (10) selon l'une des revendications 1 à 18 ou pour faire fonctionner un centre de calcul selon la revendication 19 ou 20,
- un composant informatique, notamment un serveur (17), étant incorporé de manière entièrement automatique dans l'enveloppe (12) au moyen d'un système de préparation de commandes,
- les paramètres d'une régulation de température étant adaptés à une température maximale admissible du ou des composants informatiques dans l'arrangement, et
- la régulation de température de l'arrangement fonctionnant avec les paramètres adaptés.

22. Procédé pour faire fonctionner un arrangement (10) selon l'une des revendications 1 à 18 ou pour faire fonctionner un centre de calcul selon la revendication 19 ou 20,
- un composant informatique, notamment un serveur (17), étant retiré de manière entièrement automatique de l'enveloppe (12) au moyen d'un système de préparation de commandes,
- les paramètres d'une régulation de température étant adaptés à une température maximale admissible des composants informatiques restants dans l'arrangement, et
- la régulation de température de l'arrangement fonctionnant avec les paramètres adaptés.
